# EUROPÄISCHE PATENTANMELDUNG

(11) **EP 1 027 949 A1**
(43) Veröffentlichungstag der Anmeldung: **16.08.2000**
(21) Anmeldenummer: 00102105.4
(22) Anmeldetag: 03.02.2000
(51) Int. Cl.: B23D 59/00, B23D 59/02

(54) **Innenlochsäge und Verfahren zum Justieren einer Düse und eines Sensors einer Innenlochsäge relativ zu einem Sägeblatt der Innenlochsäge**

(30) Priorität: 11.02.1999 DE 19905751
(71) Anmelder: Wacker Siltronic Gesellschaft für Halbleitermaterialien Aktiengesellschaft, 84489 Burghausen (DE)
(72) Erfinder: Kurtze, Wolf-R-diger, 84489 Burghausen (DE); Neussl, Leopold, 5145 Neukirchen (AT); Bernecker, Hermann, 5122 Hochburg/Ach (AT)
(74) Vertreter: Rimböck, Karl-Heinz, Dr.

(57) **Zusammenfassung**

Gegenstand der Erfindung ist eine Innenlochsäge zum Abtrennen einer Scheibe von einem Werkstück, umfassend ein Sägeblatt mit einer Schneidkante, einen Sensor, der eine axiale Auslenkung des Sägeblatts registriert, und mindestens eine Düse, die zu einer Mitte der Schneidkante gerichtet ist. Die Innenlochsäge ist gekennzeichnet durch einen Block, der den Sensor und die Düse in einer festgelegten Position fixiert hält. Die Erfindung betrifft auch ein Verfahren zum Justieren einer Düse und eines Sensors einer Innenlochsäge relativ zu einem Sägeblatt der Innenlochsäge, das dadurch gekennzeichnet ist, daß die Düse und der Sensor in einem Block untergebracht werden, und eine Referenzfläche des Blocks in einen vorgesehenen Abstand zum Sägeblatt gebracht wird, wobei der Block derart ausgebildet ist, daß bei eingestelltem vorgesehenen Abstand ein von der Düse austretender Flüssigkeitsstrahl vom Sägeblatt in im wesentlichen gleiche Teile gespalten wird, und der Block unter Beibehalten des Abstands positionstreu befestigt wird.

## Beschreibung

Gegenstand der Erfindung ist eine Innenlochsäge zum Abtrennen einer Scheibe von einem Werkstück, umfassend ein Sägeblatt mit einer Schneidkante, einen Sensor, der eine axiale Auslenkung des Sägeblatts registriert, und mindestens eine Düse, die zu einer Mitte der Schneidkante gerichtet ist. Die Erfindung umfaßt auch ein Verfahren zum Justieren einer Düse und eines Sensors einer Innenlochsäge relativ zu einem Sägeblatt der Innenlochsäge.

Die axiale, senkrecht zur Schneidrichtung gerichtete Auslenkung des Sägeblatts sollte beim Innenlochsägen innerhalb strenger Limits bleiben, damit die Scheibe die erwartete Form erhält. Eine Abweichung des Sägeblatts von einer vorgesehenen axialen Position kann auch durch die Beaufschlagung des Sägeblatts mit einer Flüssigkeit hervorgerufen werden. Beim Innenlochsägen durchläuft das Sägeblatt in der Regel stabile und labile Zustände. Ein labiler Zustand des Sägeblatts ist erreicht, wenn bereits eine geringfügige, ungleichmäßige Beaufschlagung der Seiten des Sägeblatts mit einer Flüssigkeit, beispielsweise einer Schneidflüssigkeit ausreicht, um eine axiale Auslenkung des Sägeblatts zu erreichen. Im ungünstigsten Fall treten Kräfte auf, die die fast gesägte Scheibe brechen läßt oder vor der Entnahme aus der Innenlochsäge aus der Halterung reißt.

Gemäß der EP-269 997 A2 gehört es zum Stand der Technik, beim Innenlochsägen Schneid- und Spülflüssigkeiten mit dünnen Metallrohren, die mit einem Schutzschlauch versehen sind, an die Schneidkante des Sägeblatts heranzuführen. Solche Düsen haben den Nachteil, daß das Metallrohr beim Berühren oder beim Sägebetrieb leicht aus der vorgesehenen Position gerät und somit eine genaue Justierung auf Dauer nicht gewährleistet ist. Weiterhin läßt sich manchmal beobachten, daß ein auf das Metallrohr aufgesteckter Kunststoffschlauch nach einiger Zeit einseitig eingesägt ist, was zu einer unterschiedlichen Flüssigkeitsverteilung auf den Seiten des Sägeblatts führt.

Die Erfindung löst die Aufgabe, Mittel bereitzustellen, durch die die genannten Nachteile einer fehljustierten Düse nicht entstehen und durch die sicher auszuschließen ist, daß eine Abweichung des Sägeblatts aus einer Ideallage auf eine Fehljustierung einer Düse zurückzuführen ist.

Gelöst wir die Aufgabe durch eine Innenlochsäge zum Abtrennen einer Scheibe von einem Werkstück, umfassend ein Sägeblatt mit einer Schneidkante, einen Sensor, der eine axiale Auslenkung des Sägeblatts registriert, und mindestens eine Düse, die zu einer Mitte der Schneidkante gerichtet ist, wobei die Innenlochsäge gekennzeichnet ist durch einen Block, der den Sensor und die Düse in einer festgelegten Position fixiert hält.

Gegenstand der Erfindung ist auch ein Verfahren zum Justieren einer Düse und eines Sensors einer Innenlochsäge relativ zu einem Sägeblatt der Innenlochsäge, das dadurch gekennzeichnet ist, daß die Düse und der Sensor in einem Block untergebracht werden, und eine Referenzfläche des Blocks in einen vorgesehenen Abstand zum Sägeblatt gebracht wird, wobei der Block derart ausgebildet ist, daß bei eingestelltem vorgesehenen Abstand ein von der Düse austretender Flüssigkeitsstrahl vom Sägeblatt in im wesentlichen gleiche Teile gespalten wird, und der Block unter Beibehalten des Abstands positionstreu befestigt wird.

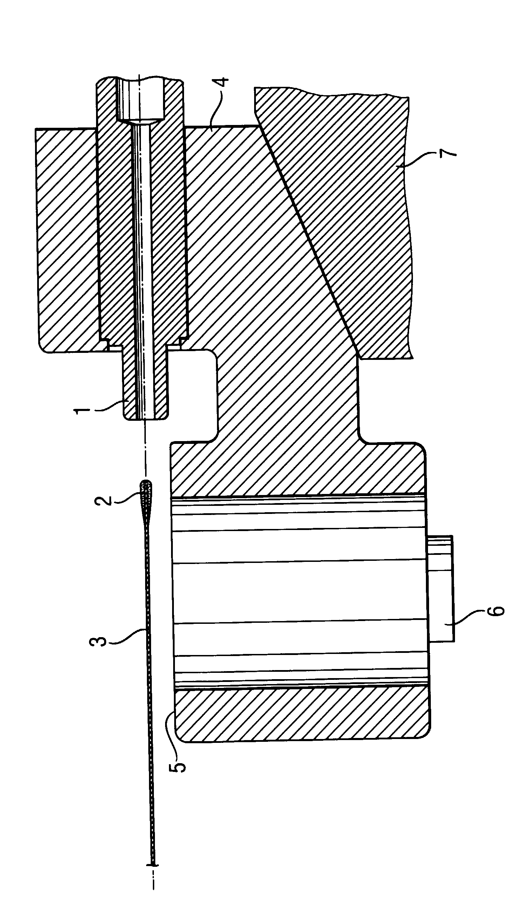

Die Erfindung wird nachfolgend anhand einer Figur näher erläutert. Die Figur zeigt in schematischer Darstellung die wesentlichen Merkmale der Erfindung.

Die Düse 1 ist zur Mitte der Schneidkante 2 des Sägeblatts 3 der Innenlochsäge zeigend ausgerichtet. Die Schneidkante besteht aus einem Belag, der auf dem Innenumfang des Sägeblatts abgeschieden ist. Eine exakte Justierung der Düse 1 gelingt mit Hilfe eines Blocks 4, in den die Düse beispielsweise spielfrei eingesteckt oder eingeschraubt werden kann. Zu diesem Zweck verfügt der Block 4 über eine ebene Referenzfläche 5 und ist derart ausgebildet, daß ein von der Düse austretender Flüssigkeitsstrahl vom Sägeblatt in im wesentlichen gleiche Teile gespalten wird, sofern zwischen der Referenzfläche und dem gespannten Sägeblatt ein bestimmter, vorgesehener Abstand besteht. Der vorgesehene Abstand kann beispielsweise mit Hilfe eines Haarlineals und eines auf den Abstand abgestimmten Meßnormals eingestellt werden. Der mit dem gewünschten Abstand zum Sägeblatt ausgerichtete Block wird an einem nicht bewegten Maschinenteil 7 der Innenlochsäge, beispielsweise am Lagerstator oder dem Maschinengestell befestigt. Ist der Block in der vorgesehenen Position fixiert, befinden sich die Mitten des Sägeblatts, der Schneidkante und der Düsenbohrung in einer Ebene.

Der Block 4 nimmt auch einen auf dem Gebiet des Innenlochsägens üblichen Sensor 6 auf, der eine axiale Auslenkung des Sägeblatts aus einer Ideallage registriert. Der Sensor ist in einer Bohrung des Blocks befestigt und schließt vorzugsweise mit der zum Sägeblatt gerichteten Referenzfläche 5 des Blocks eben ab.

Die Düse ist bei Beschädigung jederzeit auswechselbar. Die Bohrung der Düse kann relativ klein gehalten werden, da die Flüssigkeit eines Flüssigkeitsstrahls, beispielsweise das Wasser eines Wasserstrahles, der breiter als der Schneidbelag ist, zum Benetzen oder Reinigen des Schneidbelages nichts beiträgt. Der Durchmesser der Düsenbohrung beträgt vorzugsweise 1 bis 5mm, sollte jedoch nicht kleiner als 0,5 mm sein.

Die Düse wird vorzugsweise als Schneidwasserdüse oder als Reinigungsdüse eingesetzt. In der Funktion als Schneidwasserdüse benetzt sie den Schneidbelag bei dessen Eintritt in das Werkstück, in der Funktion als Reinigungsdüse benetzt sie den Schneidbelag nach dessen Austritt aus dem Werkstück. Gemäß einer Weiterbildung der Erfindung ist vorgesehen, auch zwei oder mehrere Düsen in einem Block unterzubringen, wobei solche Düsen auch andere als die genannten Funktionen ausüben können.

Der in der Figur gezeigte mechanische Aufbau gewährleistet einen Düsenwechsel, ohne daß danach die Düse 1 nachjustiert werden muß. Es ist lediglich erforderlich, die einzuwechselnde Düse in die durch das Herausnehmen der auszuwechselnden Düse frei werdende Aufnahme im Block 4 zu bringen. Durch den im Düsenblock integrierten Sensor 6 ist es außerdem einfach, den Block 4 zu demontieren und ihn wieder in der selben Position zu installieren, weil dazu lediglich der vom Sensor vor dem Ausbau registrierte Abstand zum Sägeblatt wiederhergestellt werden muß. Die Düse 1 wird auch dann wieder dieselbe Position einnehmen, wie vor der Demontage.

Die Erfindung bewirkt, daß die Düse auf einfache Weise und doch mit hoher Präzision so ausgerichtet werden kann, daß ein aus der Schneidwasserdüse austretender Flüssigkeitsstrahl vom Sägeblatt in im wesentlichen gleiche Teile gespalten wird. Durch die gleichmäßige Verteilung der Flüssigkeit wird die Sägeblattposition fluiddynamisch nicht beeinflußt und das Abtrennen einer Scheibe stabilisiert. Die vorgeschlagene Vorrichtung ist mechanisch so stabil, daß ein Verstellen der Position der Düse durch übliche Handhabung ausgeschlossen werden kann. Tritt eine Verschlechterung im Trennergebnis auf, d.h. sinkt beispielsweise die Ebenheit der abgetrennten Scheibe unter eine gesetzte Toleranzschwelle, kann sicher ausgeschlossen werden, daß die Verschlechterung auf den Einfluß einer Düse zurückgeht, deren vorgesehene Position sich verändert hat.

Durch den Einsatz der Erfindung kann der Flüssigkeitsverbrauch reduziert und das Trennverhalten der Innenlochsäge stabilisiert werden. Für Wasser als Schneidflüssigkeit beträgt der Verbrauch vorzugsweise von 1 bis 5 l/h. Die Verbesserung des Trennverhaltens macht sich insbesondere durch gleichmäßigere Schnittverläufe, verbesserte Ebenheit und Parallelität der abgetrennten Scheiben und dem selteneren Auftreten von Scheibenrand-Beschädigungen bemerkbar. Darüber hinaus muß der Betrieb der Innenlochsäge seltener wegen Überschreitung einer zulässigen axialen Auslenkung des Sägeblatts unterbrochen werden.

Die Erfindung eignet sich insbesondere zum Abtrennen von Halbleiterscheiben, wie Scheiben aus Silicium oder Siliciumcarbid. Grundsätzlich ist die Erfindung auch auf andere Sägeverfahren anwendbar, insbesondere auf das Abtrennen einer Scheibe mit Aussentrennsägen, Bandsägen und Drahtsägen. Je nach eingesetzter Breite des Trennwerkzeuges ist die Düsengröße variabel. Beim Drahtsägen können mehrere Düsen um den Draht (in radialer Richtung) und in Drahtlängsrichtung angeordnet sein.

## Patentansprüche

1. Innenlochsäge zum Abtrennen einer Scheibe von einem Werkstück, umfassend ein Sägeblatt mit einer Schneidkante, einen Sensor, der eine axiale Auslenkung des Sägeblatts registriert, und mindestens eine Düse, die zu einer Mitte der Schneidkante gerichtet ist, gekennzeichnet durch einen Block, der den Sensor und die Düse in einer festgelegten Position fixiert hält.

2. Innenlochsäge nach Anspruch 1, dadurch gekennzeichnet, daß der Block über eine Referenzfläche verfügt und derart ausgebildet ist, daß bei einem bestimmten Abstand zwischen der Referenzfläche und dem Sägeblatt ein von der Düse abgegebener Flüssigkeitsstrahl vom Sägeblatt in im wesentlichen gleiche Teile gespalten wird.

3. Innenlochsäge nach Anspruch 1 oder Anspruch 2, dadurch gekennzeichnet, daß der Block an einem Lagerstator der Innenlochsäge befestigt ist.

4. Innenlochsäge nach Anspruch 1 oder Anspruch 2, dadurch gekennzeichnet, daß der Block an einem Maschinengestell der Innenlochsäge befestigt ist.

5. Verfahren zum Justieren einer Düse und eines Sensors einer Innenlochsäge relativ zu einem Sägeblatt der Innenlochsäge, dadurch gekennzeichnet, daß die Düse und der Sensor in einem Block untergebracht werden, und eine Referenzfläche des Blocks in einen vorgesehenen Abstand zum Sägeblatt gebracht wird, wobei der Block derart ausgebildet ist, daß bei eingestelltem vorgesehenen Abstand ein von der Düse austretender Flüssigkeitsstrahl vom Sägeblatt in im wesentlichen gleiche Teile gespalten wird, und der Block unter Beibehalten des Abstands positionstreu befestigt wird.
